# EUROPÄISCHE PATENTSCHRIFT

(11) **EP 3 054 352 B1**
(45) Veröffentlichungstag und Bekanntmachung des Hinweises auf die Patenterteilung: **08.11.2017**
(21) Anmeldenummer: 16154173.5
(22) Anmeldetag: 04.02.2016
(51) Int. Cl.: G03F 7/20, G01N 21/00

(54) **AUTOMATISIERTE UV-LED BELICHTUNG VON FLEXODRUCKPLATTEN**
AUTOMATED UV-LED EXPOSURE OF FLEXOGRAPHIC PRINTING PLATES
ÉCLAIRAGE À DEL UV AUTOMATISÉ DE PLAQUES DE FLEXOGRAPHIE

(30) Priorität: 06.02.2015 EP 15154057
(43) Veröffentlichungstag der Anmeldung: 10.08.2016
(73) Patentinhaber: Flint Group Germany GmbH, 70469 Stuttgart (DE)
(72) Erfinder: Boyksen, Frank, 71155 Altdorf (DE)
(74) Vertreter: Schuck, Alexander

(56) Entgegenhaltungen:
- WO-A1-2015/007667
- WO-A1-2015/044437
- WO-A2-2008/135865
- DE-A1-102010 031 527
- US-A1- 2008 280 227

## Beschreibung

Die vorliegende Erfindung betrifft ein automatisiertes Verfahren zur UV-LED-Belichtung von Flexodruckplatten unter Einsatz von Ultraschallsensoren.

Das am weitesten verbreitete Verfahren zur Herstellung von Flexodruckformen umfasst die bildmäßige Belichtung der fotopolymerisierbaren reliefbildenden Schicht mit aktinischer Strahlung, vor allem langwelliger UV-Strahlung, durch eine fotografisch oder digital erstellte Maske. In einem weiteren Verfahrensschritt wird die belichtete Schicht mit einem geeigneten Lösemittel bzw. Lösemittelgemisch behandelt, wobei die unbelichteten, nicht polymerisierten Bereiche der reliefbildenden Schicht gelöst werden, während die belichteten, polymerisierten Bereiche erhalten bleiben und das Relief der Druckplatte bilden.

Digitale Bebilderung von fotoempfindlichen Flexodruckelementen ist prinzipiell bekannt. Hierbei werden Flexodruckelemente nicht auf klassische Art und Weise durch Auflegen einer fotografischen Maske, gefolgt vom Belichten durch die fotografische Maske hindurch erzeugt. Die Maske wird vielmehr mittels geeigneter Techniken in-situ direkt auf dem Flexodruckelement erzeugt. Flexodruckelemente können beispielsweise mit opaken, IRablativen Schichten (EP-B 654 150, EP-A 1 069 475) versehen werden, die mittels IR-Lasern bildmäßig ablatierbar sind. Weitere bekannte Techniken umfassen mittels Ink-Jet-Technik beschreibbare Schichten (EP-A 1 072 953) oder thermografisch beschreibbare Schichten (EP-A 1 070 989). Nach dem bildmäßigen Beschreiben dieser Schichten mittels der dazu geeigneten Techniken wird die fotopolymerisierbare Schicht durch die gebildete Maske hindurch mit aktinischem Licht belichtet.

Die bildmäßige Belichtung mit aktinischer Strahlung erfolgt standardmäßig unter Verwendung von UV-Strahlungsquellen, die im Bereich von ca. 315 nm bis 420 nm (langwelliger UV-Bereich bis Violettbereich des sichtbaren Spektrums) eine signifikante Emission besitzen. Am häufigsten werden als Strahlungsquelle UV/A-Röhren verwendet, welche ein Emissionsmaximum bei einer Wellenlänge von ca. 370 nm besitzen und UV-Intensitäten von 10 mW/cm² - 30 mW/cm², gemessen in einem Abstand von 50 mm (typischer Abstand der Strahlungsquelle von der Oberfläche des Flexodruckelements) erzeugen. Solche UV/A-Röhren sind beispielsweise unter der Bezeichnung "R-UVA TL 10R" von Philips erhältlich. Weiterhin werden auch Quecksilberdampflampen für die bildmäßige Belichtung verwendet, wobei dotierte Quecksilbermitteldruckdampflampen bevorzugt werden, da z.B. mittels Eisen- und/oder Galliumdotierung der im UV/A-Bereich emittierte Anteil erhöht werden kann.

In jüngster Zeit werden zur Strahlungshärtung von fotopolymerisierbaren Zusammensetzungen zunehmend auch UV-Licht emittierende LEDs (Light Emitting Diodes) eingesetzt.

Gängige LED-Systeme für die UV-Härtung konzentrieren sich in der Praxis gegenwärtig auf die Wellenlängen 395 nm sowie 365 nm. Weitere mögliche Spektralbereiche sind 350 nm, 375 nm, 385 nm, 405 nm. In wissenschaftlichen Veröffentlichungen werden außerdem noch die Wellenlängen 210, 250 nm, 275 nm und 290 nm erwähnt. LEDs zeichnen sich durch eine schmale Intensitätsverteilung (typischer Weise +/- 10 - 20 nm) aus. Sie haben keine nennenswerte Aufwärmphase und sind von ca. 1 bis 100% der Maximalintensität regelbar.

Mit UV-Leuchtdioden lassen sich Leistungswerte von einigen Watt/cm² erzielen, und der Wirkungsgrad liegt je nach UV-LED-System zwischen 1 und 20%. Dabei kann die grobe Faustregel gelten: je kürzer die Wellenlänge, desto geringer der Wirkungsgrad. Je kürzer die Emissionswellenlänge sein soll, desto höher die Herstellkosten. Gegenwärtig sind LED-Systeme für die Flächenhärtung kommerziell bei einer Wellenlänge von 395 nm mit einer UV-Leistung zwischen 1-4 W/cm² und bei einer Wellenlänge von 365 nm im Bereich von 0,5-2 W/cm² von verschiedenen Anbietern erhältlich.

Während der Belichtung von Fotopolymerplatten mit UV-Licht durch eine durch Laserablation erzeugte Maske tritt als unerwünschter Effekt die Inhibierung der Polymerisation durch Sauerstoff auf, der aus der Umgebungsatmosphäre in die Fotopolymerschicht eindiffundiert. Der gleiche Effekt tritt auf, wenn eine mittels anderer Techniken digital bebilderbare Schicht eingesetzt wird, da diese Schichten im Allgemeinen nur einige Mikrometer dick und damit so dünn sind, dass der Sauerstoff aus der Umgebungsluft durch sie hindurch diffundieren kann.

Die Inhibierung durch Sauerstoff führt dazu, dass die Oberflächen der Rasterpunkte abgerundet sind. Kleinere Rasterpunkte können nicht ausreichend polymerisieren und werden beim Auswaschprozess entfernt. Die Auflösung der unter Sauerstoffeinfluss hergestellten Flexodruckklischees ist niedrig.

Eine Möglichkeit, den Luftsauerstoff bei der Belichtung auszuschalten, ist beispielsweise die Belichtung unter Stickstoff, wie in US 2009/0186308 beschrieben. In anderen Verfahren wird eine Folie oder eine andere Sauerstoff sperrende Schicht vor der flächigen UV-Belichtung auflaminiert und so die Nachdiffusion des Sauerstoffs verhindert, wie in US 2013/0017493 beschrieben. Die Sperrschicht kann auch in den Aufbau der Flexodruckplatte integriert werden, wie beispielsweise in US 5,262,275 oder in US 8,492,074 beschrieben. Oder es werden photopolymerisierbare Schichten beschrieben, die Zusätze enthalten, die den Einfluss des Sauerstoffs bei der Vernetzungsreaktion ausschalten, wie in US 8,808,968 beschrieben. In all den genannten Verfahren können feinere Details auf der Flexodruckform reproduziert werden.

Ein elegantes Verfahren, hochauflösende Flexodruckformen herzustellen, ist die Belichtung der Flexodruckplatte mittels energiereicher UV-LED-Strahlung. In diesem Verfahren wird der Sauerstoff nicht eliminiert, sondern dessen inhibierender Einfluss durch der Belichtung mit energiereicher Strahlung minimiert.

Beispielsweise ist in der WO 2012/010459 die kombinierte Belichtung einer Flexodruckform mittels energiereicher UV-LED-Strahlung, gefolgt von einer Belichtung mit konventionellen UV-Röhren beschrieben. Die Belichtung wird in einer flachen Ausführungsform beschrieben.

Die US 2011/0104615 beschreibt das Verfahren der UV-LED-Belichtung vorzugsweise auf einem Trommelbelichter, an dem seitlich eine UV-LED-Leiste angebracht ist, die sich parallel zur Trommelachse bewegt, während die Trommel rotiert. Die Rotationsgeschwindigkeit der Trommel und damit die pro Belichtungszyklus eingetragene Energie kann variiert werden. Durch Wahl der Umdrehungsgeschwindigkeit hat der Operator die Möglichkeit zu steuern, ob runde oder flache Rasterpunkte auf der Flexodruckform erzeugt werden.

Auch eine flache Ausführungsform der UV-LED-Belichtung wird beschrieben, wobei die UV-LED-Belichtungseinheit über der Breite der Druckplatte hin- und her geführt wird, während die Druckplatte in Längsrichtung verschoben wird.
In der US 8,772,740 wird beschrieben, wie auf einer Druckplatte mittels UV-LED-Belichtung sowohl Rasterpunkte mit flacher Oberfläche als auch an der Oberfläche abgerundete Rasterpunkte erzeugt werden können. Hier wird die Druckplatte ein erstes Mal mit einem Laser beschrieben und dann so belichtet, dass Rasterpunkte mit flacher Oberfläche entstehen. Anschließend wird die Druckplatte ein zweites Mal mit einem Laser beschrieben und dann so belichtet, dass abgerundete Rasterpunkte entstehen. Allerdings ist das Verfahren sehr aufwendig und hat sich deshalb in der Praxis nicht durchgesetzt.

In der US 8,578,854 wird die UV-LED-Belichtung von Flexodruckplatten beschrieben, bei der sich die UV-LED-Belichtungseinheit in einem Reflektortunnel befindet. In dem Reflektortunnel wird die UV-LED-Strahlung zusätzlich gestreut, wodurch sich Rasterpunkte mit breiterer Versockelung realisieren lassen. Das Verfahren lässt sich für flache und runde Druckformen realisieren.

Schließlich beschreibt die WO 2014/035566 eine Flexodruckplatte, die mittels UV-LEDs belichtet wird, wobei die Belichtung mit zwei unterschiedlichen Wellenlängen (365 nm und 395 nm) erfolgt. Diese Art der Belichtung soll es ermöglichen, die Versockelung und den Flankenwinkel der Rasterpunkte zu steuern, um ein gutes Druckergebnis zu erreichen.

Allen UV-LED-Belichtungsarten ist gemeinsam, dass es zahlreiche verschiedene Parameter gibt, die das Belichtungsergebnis beeinflussen können. Wichtige Parameter sind beispielsweise der Abstand der UV-LED-Leiste zur Druckplattenoberfläche, die Lichtleistung der UV-LED-Leiste, der Abstrahlwinkel, die Wellenlänge, die Vorschubgeschwindigkeit der UV-LED-Leiste oder bei Belichtung auf einer Trommel die Rotationsgeschwindigkeit, die insgesamt in die fotopolymerisierbare Schicht eingetragene Energie und bei mehreren Teilbelichtung die pro Teilbelichtung eingetragene Energie.

Diese verschiedenen Parameter ermöglichen es, das Belichtungsergebnis zu steuern und beispielsweise maßgeschneiderte Belichtungseinstellungen für verschiedene Druckanwendungen zu realisieren. Mit der Variabilität der UV-LED-Belichtung geht aber auch eine hohe Fehleranfälligkeit einher. Wird nur ein Parameter nicht korrekt eingestellt, ist das verarbeitete Klischee unbrauchbar.

Aufgabe der Erfindung ist es daher, ein automatisiertes Verfahren zur UV-LED-Belichtung von Flexodruckplatten bereitzustellen, das eine Vielfalt unterschiedlicher Belichtungsarten ermöglicht, dabei aber die Fehlerhäufigkeit minimiert.

Gelöst wird die Aufgabe durch ein Verfahren zur Herstellung von Flexodruckformen, bei dem man als Ausgangsmaterial eine fotopolymerisierbare Flexodruckplatte einsetzt, welche übereinander angeordnet mindestens umfasst
- einen dimensionsstabilen Träger,
- mindestens eine fotopolymerisierbare reliefbildende Schicht, mindestens umfassend ein elastomeres Bindemittel, eine ethylenisch ungesättigte Verbindung und einen Fotoinitiator,
- eine digital bebilderbare Schicht,
umfassend mindestens die folgenden Schritte:
(a) Erzeugung einer Maske durch Bebilderung der digital bebilderbaren Schicht,
(b) Belichtung der Flexodruckplatte durch die Maske hindurch mit aktinischem Licht und Fotopolymerisation der Bildbereiche der Schicht, wobei die Belichtung mit mehreren UV-LEDs erfolgt, die auf mindestens einer relativ zur Oberfläche der Flexodruckplatte bewegten UV-LED-Leiste angeordnet sind, und
(c) Entwicklung der fotopolymerisierten Schicht durch Auswaschen und Trocknen oder durch thermische Entwicklung,
dadurch gekennzeichnet, dass
- in der UV-LED-Leiste oder in einer separaten Leiste mindestens ein Ultraschallsensor angeordnet ist,
- mit dem mindestens einen Ultraschallsensor mindestens die Dicke der zu belichtenden Flexodruckplatte bestimmt wird,
- die Belichtung der Flexodruckplatte in Abhängigkeit von der gemessenen Dicke der Flexodruckplatte hinsichtlich mindestens eines der Parameter
   (i) Zahl der Belichtungsschritte,
   (ii) Belichtungsintensität,
   (iii) Energieeintrag pro Belichtungsschritt,
   (iv) Dauer der einzelnen Belichtungsschritte,
   (v) Gesamtdauer der Belichtung
   gesteuert wird.

Vorzugsweise erfolgt die Steuerung der Belichtung hinsichtlich mehrerer Parameter (i)-(v), besonders bevorzugt hinsichtlich aller Parameter (i)-(v).

Abhängig von der gemessenen Dicke der Flexodruckplatte wird die Zahl der Belichtungsschritte, die Belichtungsintensität sowie der Energieeintrag pro Belichtungsschritt gesteuert. Der Energieeintrag pro Belichtungsschritt ergibt sich aus der Belichtungsintensität und der Geschwindigkeit, mit der die UV-LED-Leiste relativ zur Plattenoberfläche verfahren wird. Aus dieser Geschwindigkeit und der Länge der Flexodruckplatte ergibt sich die Dauer eines Belichtungsschrittes. Die Gesamtdauer der Belichtung kann abhängig von der gemessenen Länge der Flexodruckplatte durch Pausen zwischen den einzelnen Belichtungsschritten reguliert werden.

Die in die fotopolymerisierbare Schicht während der gesamten Belichtung (b) insgesamt eingetragene Energie (J/cm²) wird entsprechend der Reaktivität der Druckplatte eingestellt. Typische Energien, die zur Vernetzung einer Flexodruckplatte notwendig sind, liegen im Bereich von 5 bis 25 J/cm².

In einer bevorzugten Ausführungsform der Erfindung beträgt die in Schritt (b) in die fotopolymerisierbare reliefbildende Schicht insgesamt eingetragene Energie 5 bis 25 J/cm².

Im Allgemeinen weisen die in Schritt (b) eingesetzten UV-LEDs ein Emissionsmaximum im Wellenlängenbereich von 350 - 405 nm, beispielsweise bei 350 nm, 365 nm, 375 nm, 385 nm, 395 nm oder 405 nm auf. Die Leistung der UV-LED-Leiste liegt vorzugsweise in einem Bereich von 500 bis 5000 mW/cm².

Vorzugsweise wird diese Energie nicht in einem Belichtungsschritt in die fotopolymerisierbare Schicht eingetragen, sondern auf mehrere Teilbelichtungen (Belichtungsschritte) verteilt, bevorzugt werden mindestens 3 Teilbelichtungen durchgeführt.

Es wurde gefunden, dass bei der Belichtung der fotopolymerisierbaren Schicht mit hoher Belichtungsintensität mittels UV-LEDs das sogenannte "Cupping" der Rasterpunkte der druckenden Reliefschicht minimiert und die Zwischentiefen zwischen den Rasterpunkten vergrößert werden können, wenn die gesamte Belichtungsenergie nicht in einem einzigen Belichtungsschritt eingetragen wird, sondern auf mehrere Belichtungsschritte verteilt wird.

Im Allgemeinen wird die UV-LED-Leiste mit einer Relativgeschwindigkeit von 50 bis 5000 mm/min parallel zur Oberfläche des Flexodruckelements bewegt.

Somit wird, abhängig von der von dem mindestens einen Ultraschallsensor gemessenen Dicke der Druckplatte, die Zahl der Belichtungsschritte, die Dauer eines einzelnen Belichtungsschrittes und der Energieeintrag pro Belichtungsschritt durch Verfahren der UV-LED-Leiste mit einer Geschwindigkeit im Bereich von 50 mm/min bis 5 000 mm/min relativ zur Oberfläche der Flexodruckplatte eingestellt.

Im Allgemeinen wird mit dem mindestens einen Ultraschallsensor auch der Abstand der UV-LED-Leiste von der Oberfläche der Flexodruckplatte bestimmt und die UV-LED-Leiste in einem bestimmten Abstand zur Oberfläche der Flexodruckplatte positioniert.

In einer bevorzugten Ausführungsform des erfindungsgemäßen Verfahrens sind in der UV-LED-Leiste mehrere Ultraschallsensoren angeordnet, um zusätzlich die Breite der zu belichtenden Flexodruckplatte zu messen. Bei der Belichtung der Flexodruckplatte werden dann nur die, entsprechend der gemessenen Breite, für die Belichtung notwendigen UV-LEDs eingeschaltet.

In einer weiteren bevorzugten Ausführungsform wird die Breite der Flexodruckplatte mit nur einem Ultraschallsensor gemessen. Dieser lässt sich längs der UV-LED-Leiste verfahren.

In einer weiteren bevorzugten Ausführungsform des erfindungsgemäßen Verfahrens wird vor der UV-LED Belichtung zusätzlich auch die Länge der zu belichtenden Flexodruckplatte bestimmt. So kann das Belichtungsprogramm auf das Format der Flexodruckplatte optimal abgestimmt werden.

In einer Ausführungsform der Erfindung bleibt die pro Belichtungsschritt eingetragene Energie über die Gesamtdauer der Belichtung (b) konstant. Beispielsweise werden 10 bis 50 Belichtungsschritte mit einem Energieeintrag von 0,1 bis 1 J/cm² durchgeführt.
In einer bevorzugten Ausführungsform nimmt die pro Belichtungsschritt eingetragene Energie über die Gesamtdauer der Belichtung (b) zu, das heißt in einem späteren Belichtungsschritt wird eine höhere Energie eingetragen als in einem früheren Belichtungsschritt.

In einer bevorzugten Ausführungsform werden zuerst mehrere Belichtungsschritte mit niedrigem Energieeintrag und anschließend ein oder mehrere Belichtungsschritte mit höherem Energieeintrag durchgeführt. Beispielsweise werden zuerst 10 bis 40 Belichtungsschritte mit einem Energieeintrag von 0,1 bis 1 J/cm² und anschließend 1 bis 5 Belichtungsschritte mit 2 bis 5 J/cm² durchgeführt.

Die einzelnen Belichtungsschritte werden dadurch realisiert, dass die mindestens eine UV-LED-Leiste parallel zur Oberfläche des Flexodruckelements bewegt wird. Dabei können die UV-LED-Leiste bzw. UV-LED-Leisten beweglich sein oder die UV-LED-Leisten feststehend und die Oberfläche des Flexodruckelements beweglich sein, oder es können beide Möglichkeiten realisiert sein.

In einer Ausführungsform des erfindungsgemäßen Verfahrens wird die Flexodruckplatte bewegt. In einer bevorzugten Aus führungs form des erfindungsgemäßen Verfahrens wird die Flexodruckplatte bewegt und ist eine UV-LED-Leiste beweglich, während eine weitere UV-LED-Leiste fest angeordnet ist. In dieser Ausführungsform der Erfindung ist die Mehrzahl der UV-LEDs auf mindestens zwei UV-LED-Leisten nebeneinander angeordnet, von denen mindestens eine beweglich und mindestens eine feststehend ist. Dabei können ein oder mehrere Ultraschallsensoren an einer oder mehreren UV-LED-Leisten angeordnet sein, um den Abstand der UV-LED-Leisten zur Flexodruckplatte einzustellen und das zu belichtende Format der Flexodruckplatte zu erfassen.

In einer bevorzugten Ausführungsform der Erfindung umfasst die Belichtung mehrere Belichtungsschritte, wobei das Verfahren der UV-LED-Leiste mit unterschiedlichen Geschwindigkeiten relativ zur Flexodruckplatte erfolgt

Falls die Belichtung mehrere Belichtungsschritte umfasst, kann die Gesamtdauer der Belichtung in Abhängigkeit von der Länge der Flexodruckplatte durch Pausen zwischen den einzelnen Belichtungsschritten eingestellt werden. Dies ist dann vorteilhaft, wenn Flexodruckplatten mit unterschiedlichen Abmessungen belichtet werden sollen. Durch das Einhalten von Pausen zwischen den einzelnen Belichtungssschritten bei der Belichtung kleinerer Flexodruckplatten kann die Gesamtdauer der Belichtung konstant gehalten werden und es können kleinere und größere Flexodruckplatten mit einem identischen Belichtungsprogramm belichtet werden, so dass identische Belichtungsresultate entstehen.

In einer bevorzugten Ausführungsform der Erfindung umfasst die Belichtung mehrere Belichtungsschritte, wobei die UV-LED-Leiste beweglich ist und zwischen einer Ausgangs- und einer Endposition relativ zur Flexodruckplatte hin und her traversiert.

In einer Variante wird die UV-LED-Leiste beim Verfahren von der End- in die Ausgangsposition abgeschaltet.

In einer weiteren Variante wird die UV-LED-Leiste beim Verfahren von der End- in die Ausgangsposition nicht abgeschaltet.

Die Erfindung wird nachstehend unter Bezugnahme auf die Figuren näher erläutert. Es zeigen:
Figur 1 schematisch eine Ausführungsform mit nur einem Ultraschallsensor in der UV-LED-Leiste.
Figur 2 schematisch eine bevorzugte Ausführungsform mit mehreren Ultraschallsensoren in der UV-LED-Leiste.

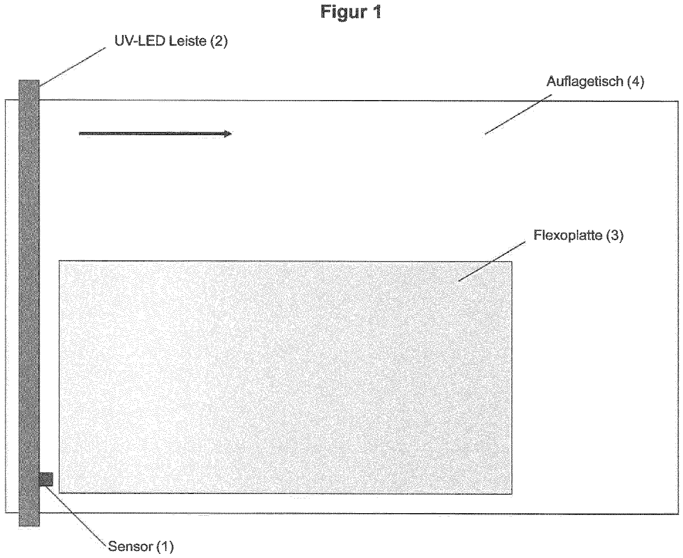

Die Belichtung (b) wird vorzugsweise auf einem XY-Tisch mit einer Breite X und einer Länge Y mittels einer oder mehrerer UV-LED-Leisten, die entlang der Oberfläche der Flexodruckplatte bewegt werden, vorgenommen. Eine Schemazeichnung eines XY- Tisches mit einer UV-LED-Leiste zeigt Figur 1. Die UV-LED-Leiste **2** erstreckt sich üblicherweise über die gesamte Breite des XY-Tisches und deckt somit die gesamte Breite des Belichters **4** ab. Während der Belichtung wird die UV-LED-Leiste mit einer bestimmten Vorschubgeschwindigkeit über die gesamte Länge der Druckplatte **3** bewegt. Diese kann beispielsweise 2 m betragen. Die Belichtung kann in einem Durchgang oder in mehreren Durchgängen (Belichtungsschritten) erfolgen. Die Vorschubgeschwindigkeit kann dabei konstant gehalten oder variiert werden. Zwischen den einzelnen Teilbelichtungen (Belichtungsschritten) können Pausen erfolgen. Die Teilbelichtungen können durch Verfahren der eingeschalteten UV-LED-Leiste nur in einer Richtung oder traversierend (durch Hin- und Herfahren der eingeschalteten UV-LED-Leiste) erfolgen.

Eine typische UV-LED-Leiste ist aus einzelnen LED-Arrays, bestehend aus jeweils 4 LEDs in quadratischer Anordnung, aufgebaut, so dass eine gleichmäßige Lichtintensität über die gesamte Länge der LED-Leiste emittiert wird. In einer typischen, 1 m langen LED-Leiste sind beispielsweise insgesamt 125 LED-Arrays, entsprechend 500 einzelnen LEDs, angeordnet. Üblicherweise werden 10 bis 20 LED-Arrays jeweils zu einzelnen Modulen zusammengesetzt. Diese Module können separat angesteuert werden.

In einer Ausführungsform ist an der vorlaufenden Seite der UV-LED-Leiste **2** ein Ultraschallsensor **1** angebracht, mit dem die Dicke der zu belichtenden Flexodruckplatte gemessen werden kann. Fährt die UV-LED-Leiste vor der eigentlichen Belichtung über die Flexodruckplatte, dann kann mit dem Ultraschallsensor 1 auch die Länge der zu belichtenden Flexodruckplatte erfasst werden. Ist der Ultraschallsensor 1 beweglich an der UV-LED-Leiste angebracht und kann längs der UV-LED-Leiste verfahren werden, dann können mit Hilfe eines Ultraschallsensors die Dicke der zu belichtenden Flexodruckplatte sowie deren Länge und Breite erfasst werden.

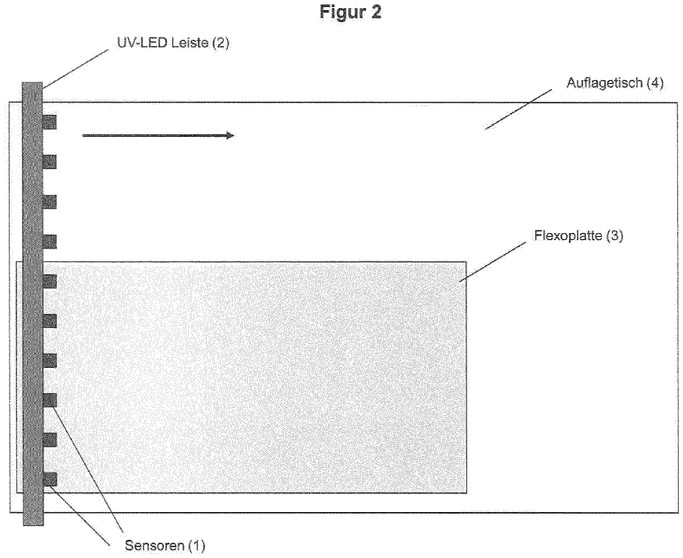

In der in Figur 2 gezeigten bevorzugten Ausführungsform ist jeweils ein Ultraschallsensor **1** pro ansteuerbarem LED-Modul angebracht, so dass neben dem Abstand der UV-LED-Leiste zur Plattenoberfläche auch Breite und Länge der zu belichtenden Flexodruckplatte automatisch erfasst werden, wenn die UV-LED-Leiste vor der eigentlichen Belichtung über der Flexodruckplatte verfahren wird.

In einer weiteren erfindungsgemäßen Anordnung sind die Sensoren **1** auf beiden Seiten der UV-LED-Leiste **2** angebracht, so dass auch im traversierenden Betrieb der UV-LED-Leiste eine automatische Steuerung möglich ist.

Die Sensoren sind mit einer Steuerungseinheit verbunden. Mit dieser Steuerungseinheit werden der Abstand der UV-LED-Leiste zur Oberfläche des Flexodruckelements eingestellt sowie alle weiteren Parameter des Belichtungsvorganges (Belichtungsintensität, Vorschubgeschwindigkeit der Leiste, An- und Abschalten der UV-LED-Leiste, Anzahl der Belichtungsschritte, Pausen zwischen einzelnen Belichtungsschritten) gesteuert.

Beispielsweise kann das erfindungsgemäße Verfahren derart durchgeführt werden, dass vor der Belichtung das zu belichtende Flexodruckelement **3** in einer Ecke des XY-Tisches **4** positioniert wird. Daraufhin verfährt die UV-LED-Leiste **2** einige cm über die Platte, wobei die Sensoren **1** die Breite des Flexodruckelements sowie dessen Dicke erfassen. Die von den Sensoren ermittelten Daten werden an die Steuerungseinheit übermittelt. Die UV-LED-Leiste fährt wieder in die Ausgangsposition zurück. Nun wird das in der Steuerungseinheit hinterlegte Belichtungsprogramm für die betreffende Plattendicke gestartet.

Die UV-LED-Leiste startet mit der jeweils gewählten Vorschubgeschwindigkeit. Sobald die Sensoren den Rand der Druckplatte erfassen, schaltet sich die UV-LED-Leiste mit der vom Belichtungsprogramm gewählten Lichtleistung automatisch ein. Um Energie zu sparen werden nur die LED-Module eingeschaltet, die sich über der Druckplatte befinden. Sobald die Sensoren das Ende der Druckplatte erfassen, schaltet sich die UV-LED-Leiste automatisch ab und verfährt mit maximaler Vorschubgeschwindigkeit in die Ausgangsposition zurück. Nach einer Pause, sofern erforderlich, startet die nächste Teilbelichtung mit der im Belichtungsprogramm hinterlegten Vorschubgeschwindigkeit und Lichtleistung. Diese Prozesse werden solange wiederholt, bis das in der Steuereinheit hinterlegte Belichtungsprogramm abgearbeitet ist.

Alternativ hierzu kann vor der Belichtung die UV-LED-Leiste über die gesamte Flexodruckplatte verfahren werden und so das Format der zu belichtenden Flexodruckplatte erfasst werden.

Zur Erzeugung optimaler Rasterpunktformen kann es ferner erforderlich sein, den Energieeintrag der Teilbelichtungen im Laufe der Belichtung zu steigern. Beispielsweise werden zunächst mehrere Teilbelichtungen mit hoher Vorschubgeschwindigkeit (d.h. geringem Energieeintrag) und anschließend eine Teilbelichtung mit niedriger Vorschubsgeschwindigkeit (d.h. hohem Energieeintrag) durchgeführt. Oder die Vorschubgeschwindigkeit wird kontinuierlich erniedrigt bzw. der Energieeintrag der Teilbelichtungen im Verlauf der Belichtung kontinuierlich gesteigert.

Die in der Druckplatte ablaufenden Vorgänge bei Bestrahlung mit UVA-Licht sind komplex und wirken sich, abhängig von der Dicke der fotopolymerisierbaren reliefbildenden Schicht der Flexodruckplatte, jeweils unterschiedlich aus. Es laufen mehrere Vorgänge parallel ab, die in drei Dimensionen zu berücksichtigen sind, um die Entstehung der für den späteren Druck optimalen Rasterpunktgeometrie erklären und beeinflussen zu können.

Nach Absorption des UVA-Lichtes zerfällt ein in der Druckplatte vorhandenes Fotoinitiatormolekül in zwei Radikale. Die entstehenden Radikale reagieren in einer radikalischen Kettenreaktion mit dem in der Druckplatte vorhandenen niedermolekularen Vernetzer. Da der Vernetzer multifunktionell ist, kommt es durch die Polymerisation zur Ausbildung von Netzwerken, die zur Unlöslichkeit der belichteten Bereiche der Druckplatte führen. Die Geschwindigkeit der Fotopolymerisation ist in der Regel sehr schnell und in erster Näherung von der Konzentration des zur Verfügung stehenden Vernetzers und der zur Verfügung stehenden Radikale abhängig.

Radikalische Kettenreaktionen werden durch Anwesenheit von Sauerstoff inhibiert, da Sauerstoff reaktive Radikale abfängt und in stabilere Radikale, die für die weitere Polymerisation nicht mehr zur Verfügung stehen, umwandelt.

Bei einer typischen Röhrenbelichtung wird die Druckplatte für eine Zeit von ca. 10 Minuten mit UVA-Licht niedriger Leistung (ca. 20mW/cm²) bestrahlt. Bei dieser niedrigen Leistung liegt die Geschwindigkeit der Kettenstartreaktion in derselben Größe wie die Geschwindigkeit der Kettenabbruchreaktion. In den belichteten Bereichen der Druckplatte läuft daher als Konkurrenzreaktion zu der durch Radikalbildung gestarteten Polymerisation die Abbruchsreaktion mit Sauerstoff ab. An der Oberfläche der Druckplatte kann Sauerstoff aus der Umgebungsluft nachdiffundieren. Deshalb werden Rasterpunkte bei der Röhrenbelichtung an der Oberfläche der Druckplatte üblicherweise nicht exakt abgebildet, sondern weisen abgerundete Punktoberflächen auf. Der Fachmann spricht von sogenannten Round-Top-Dots (RTD).

Bei der UV-LED-Belichtung werden höhere Strahlungsdosen in sehr viel kürzerer Zeit in die Platte eingetragen. Bei einer typischen UV-LED-Belichtung liegt die abgestrahlte Leistung bei ca. 1000 mW/cm². Bei einer üblichen Bestrahlungsbreite von etwa 30 mm und Vorschubgeschwindigkeiten von 100 bis 5 000 mm/min liegt die Belichtungszeit unter einer Minute, meist im Bereich weniger Sekunden. Unter diesen Bedingungen ist die Konzentration der durch Lichtabsorption erzeugten Radikale in den belichteten Bereichen der fotopolymerisierbaren Schicht um Größenordnungen höher als bei der Röhrenbelichtung. Die Kettenstartreaktion ist sehr viel schneller als die Kettenabbruchreaktion. Der in der fotopolymerisierbaren Schicht anwesende oder nachdiffundierende Sauerstoff kann die Fotopolymerisation nicht mehr wesentlich beeinflussen. Die Rasterpunkte werden daher exakt bis zur Grenze zum unbelichteten Bereich abgebildet. Es entstehen Rasterpunkte mit scharfen Rändern. Der Fachmann spricht von sogenannten Flat-Top-Dots (FTD).

Erfindungsgemäß kann die Belichtung so erfolgen, dass FTD-Rasterpunkte entstehen. Die Kettenstartreaktion ist sehr viel schneller als die durch Sauerstoff bewirkte Kettenabbruchreaktion. Trotzdem spielen die Gegenwart von der Sauerstoff und dessen Nachdiffusion immer noch eine erhebliche Rolle an der Grenze zwischen belichteten und unbelichteten Bereichen der Druckplatte.

Ohne an eine bestimmte Theorie gebunden zu sein wird vermutet, dass unter UV-LED-Belichtungsbedingungen ein weiterer Effekt zu berücksichtigen ist. Durch die hohe Belichtungsintensität kommt es in den belichteten Bereichen der Druckplatte zu einer schlagartigen Abreicherung des Vernetzers. Die Reaktion läuft anschließend diffusionskontrolliert ab und wird durch Diffusion des Vernetzers aus den benachbarten, nicht belichteten Bereichen gespeist. Die Diffusion des Vernetzers ist aber vergleichsweise langsam und wirkt sich daher nur in einem engen Bereich um die Grenze von Bild- zu Nichtbildbereichen aus. Durch die Diffusion des Vernetzers kommt es an der Grenze zwischen unbelichteten und belichteten Bereichen der Druckplatte zu einem signifikanten Materialtransport, der die Punktform des Rasterpunktes und insbesondere die Ränder des Rasterpunktes wesentlich bestimmt. Das Phänomen der Ausbildung von messbaren Rändern an den Grenzen der Bildelemente ist dem Fachmann bekannt. Er spricht vom Cupping. Der Zusammenhang des sogenannten Cuppings mit der Diffusion des Vernetzers in der photopolymerisierbaren Schicht wurde bislang aber nicht erkannt.

Somit konkurrieren bei der Belichtung von Flexodruckplatten mit energiereicher UV-LED-Strahlung die Prozesse (1) Lichtabsorption und Radikalbildung, (2) Polymerisation, (3) Diffusion von Sauerstoff in die fotopolymerisierbare Schicht und Kettenabbruch sowie (4) Diffusion des Vernetzers in der fotopolymerisierbaren Schicht miteinander und bestimmen im Zusammenspiel und abhängig von der Dicke der Flexodruckplatte die Form der Reliefelemente und damit auch deren Druckverhalten.

Zur Messung der Lichtintensität auf Höhe der Oberfläche der Flexodruckplatte wird ein geeignetes, kalibriertes UV-Messgerät verwendet, wobei der Sensor des Messgeräts im gleichen Abstand von der Strahlungsquelle platziert wird, den die Plattenoberfläche von der Strahlungsquelle haben würde. Geeignete UV-Messgeräte sind im Handel von verschiedenen Anbietern erhältlich. Wichtig hierbei ist, dass das Messgerät im zu prüfenden UV-Wellenlängenbereich sensitiv und kalibriert ist.

Soll eine Flexodruckplatte mit mehreren Teilbelichtungen mit hoher Vorschubsgeschwindigkeit belichtet werden, so ist es sinnvoll, die UV-LED-Leiste hin- und her zu verfahren und dabei die UV-LED-Leiste beim Zurückverfahren in die Ausgangsposition nicht abzuschalten, wodurch eine signifikante Zeitersparnis erzielt werden kann.

Insbesondere bei dickeren Flexodruckplatten kann es erforderlich sein, die UV-LED-Belichtung mit einer anschließenden flächigen Belichtung durch UVA-Röhren zu kombinieren. Diese Röhren können oberhalb des XY-Tisches angebracht sein und von der Steuerungseinheit automatisch gestartet werden, sobald die UV-LED-Belichtung beendet ist.

In einer Ausführungsform des erfindungsgemäßen Verfahrens erfolgt also nach Schritt (b) zusätzlich eine Belichtung mit einem UVA-Röhrenbelichter.

Für jeden durch seine Dicke definierten Plattentyp kann ein individuelles Belichtungsprogramm in der Steuerungseinheit hinterlegt werden, wodurch die Fehlermöglichkeiten eliminiert werden. Ebenso können für verschiedene Plattenformate unterschiedliche Belichtungsprogramme hinterlegt werden, wodurch wiederum Fehlermöglichkeiten eliminiert werden und eine wirtschaftliche, d.h. möglichst schnelle Belichtung, realisiert werden kann.

### UV-LED-Leiste

Die Leistung der UV-LED-Leiste liegt vorzugsweise in einem Bereich von 500 bis 5000 mW/cm², besonders bevorzugt in einem Bericht von 600 bis 2000 mW/cm². Diese wird mit einem UVA-Meter in einem Abstand von 10 mm zwischen Messsensor und Schutzfenster der LED-Leiste bestimmt. Dazu wird der Messsensor auf der Grundplatte des Belichters positioniert und von der Licht emittierenden UV-LED-Leiste überfahren, wobei ein Intensitätsprofil aufgezeichnet wird, dessen Maximum der Belichtungsintensität entspricht. Die an der Oberfläche der Flexodruckplatte eingestrahlte Lichtleistung ist bei größerem Abstand zwischen UV-LED-Leiste und bestrahlter Oberfläche entsprechend geringer und bei kleinerem Abstand zwischen UV-LED-Leiste und bestrahlter Oberfläche entsprechend höher. Erfindungsgemäß liegt die an der Oberfläche der Flexodruckplatte eingestrahlte Leistung (Lichtintensität) bei 100 bis 5000 mW/ cm², bevorzugt bei 500 bis 5000 mW/cm² und besonders bevorzugt bei 600 bis 2000 mW/cm². Mögliche Wellenlängen der UV-LED Leiste sind 355 nm, 365 nm, 375 nm, 395 nm, 405 nm, bevorzugte Wellenlänge ist 365 nm.

Eine typische UV-LED-Leiste besitzt eine Strahlfensterbreite von etwa 10 mm und ist aus linear angeordneten LED-Arrays, bestehend aus jeweils 4 LEDs in quadratischer Anordnung, aufgebaut, so dass eine gleichmäßige Lichtintensität über die gesamte Länge der LED-Leiste emittiert wird.

In einer typischen, 1 m langen LED-Leiste sind beispielsweise insgesamt 125 LED-Arrays, entsprechend 500 einzelnen LEDs, angeordnet. Jeweils 10 bis 20 LED-Arrays sind dabei jeweils zu einzelnen Modulen zusammengefasst. Diese Module können relativ einfach ausgetauscht werden und können separat angesteuert, d.h. an- und abgeschaltet oder in der Lichtleistung geregelt werden.

Die UV-LED-Arrays können auch versetzt angeordnet sein, um eine größere Fläche zu bestrahlen. Die UV-LED-Leiste muss dann allerdings verspiegelt werden, bevorzugt an den Seiten, um eine gleichmäßige Ausleuchtung der bestrahlten Fläche sicherzustellen.

Die UV-LED-Leiste strahlt üblicherweise Licht mit einem gewissen Abstrahlwinkel ab. Typische Abstrahlwinkel liegen in einem Bereich von 20 bis 70 Grad, bei linear aufgebauten UV-LED-Leisten in einem Bereich von 20 bis 40 Grad. Aus der Strahlfensterbreite, dem Abstrahlwinkel und dem Abstand der LED-Leiste zur Druckplattenoberfläche kann die Breite des bestrahlten Flächenelementes berechnet werden.

Üblicherweise liegt der Abstand der Leiste von der Druckplattenoberfläche bei 5 mm bis 100 mm, bevorzugt bei 5 bis 30 mm. Bei einer üblichen UV-LED-Leiste mit einer Strahlfensterbreite von etwa 10 mm liegt die Breite des bestrahlten Flächenelementes in einem Bereich von 15 bis 100 mm, bei niedrigem Abstand von ca. 10 mm zur Plattenoberfläche zwischen 15 und 40 mm.

Die Geschwindigkeit, mit der die UV-LED-Leiste relativ zur Oberfläche der Flexodruckplatte bewegt wird, liegt im Bereich von 50 mm/min bis 5 000 mm/min, bevorzugt von 100 mm/min bis 5 000 mm/min.

Aus der Breite des bestrahlten Flächenelements und der gemessenen Lichtleistung und dem gewählten Vorschub kann dann der Energieeintrag pro Teilbelichtung ermittelt werden. So beträgt beispielsweise bei einer UVA-Leistung eines LED-Belichters von 800 mW/cm², einer Breite des bestrahlten Flächenelementes von 25 mm und einer typischen Vorschubgeschwindigkeit von 250 mm/min die Bestrahlungsdauer 6 Sekunden und der Energieeintrag 4,8 J/cm².

### Ultraschallsensor

Die an der UV-LED-Leiste oder an einer separaten Leiste angebrachten Sensoren basieren auf der Reflexion von Ultraschallwellen und liefern im Allgemeinen lineare Analogsignale abhängig von der Plattendicke. Beispielsweise können mit Ultraschallsensoren der Firma Pepperl und Fuchs, 68307 Mannheim, Deutschland die Dicken aller handelsüblichen Flexodruckplatten-Typen zuverlässig gemessen werden.

Erfindungsgemäß ist jeweils mindestens ein Ultraschallsensor an der oder den UV-LED-Leisten oder einer separaten Leiste angebracht. Soll neben der Plattendicke und Plattenlänge auch die Breite der zu belichtenden Flexodruckplatte erfasst werden, ist vorzugsweise jeweils ein Dickensensor pro UV-LED-Modul auf der UV-LED-Leiste angeordnet. Alternativ kann der Ultraschallsensor auch beweglich an der UV-LED-Leiste oder der separaten Leiste angebracht werden und die Breite der zu belichtenden Flexodruckplatte durch Verfahren des Sensors entlang der UV-LED-Leiste oder der separaten Leiste ermittelt werden. Bei der Belichtung werden nur die Module angeschaltet, die zur Belichtung benötigt werden. Insbesondere bei Belichtung kleiner Plattenformate kann so erheblich viel Energie eingespart werden.

Sollen die Flexodruckplatten nicht nur in einer Richtung mittels einer UV-LED-Leiste belichtet werden, sondern auch im traversierenden Modus, dann empfiehlt sich der Einbau eines weiteren Ultraschallsensors an der nachlaufenden Seite der UV-LED-Leiste. Da dieser Sensor nur dazu dient, die UV-LED-Leiste bei der Rückwärtsbewegung ein- bzw. auszuzuschalten, ist hier ein Messsensor ausreichend.

### Flexodruckplatten-Verarbeitung

Im Allgemeinen wird eine Rückseitenvorbelichtung der Flexodruckplatte durchgeführt. Dazu wird die Schicht aus fotopolymerisierbarem Material vor Durchführung von Schritt (b) von der Rückseite der fotopolymerisierbaren Flexodruckplatte durch die UVtransparente Trägerfolie hindurch mit aktinischem Licht vorbelichtet. Die Rückseitenvorbelichtung wird vorzugsweise bei Flexodruckplatten mit einer Stärke von ≥ 1 mm durchgeführt, wobei diese Angabe sich auf die Summe aus dimensionsstabiler Trägerfolie und fotopolymerisierbarer Schicht bezieht.

Im Allgemeinen erfolgt die Rückseitenvorbelichtung mit einer UV-Röhre oder einem UV-Strahler.

Die als Ausgangsmaterial eingesetzte fotopolymerisierbare Flexodruckplatte umfasst übereinander angeordnet mindestens
- einen dimensionsstabilen Träger, und
- mindestens eine fotopolymerisierbare reliefbildende Schicht, mindestens umfassend ein elastomeres Bindemittel, eine ethylenisch ungesättigte Verbindung und einen Fotoinitiator,
- eine digital bebilderbare Schicht.

Soll eine Rückseitenvorbelichtung der Flexodruckplatte durchgeführt werden, muss der dimensionsstabile Träger für UV-Licht transparent sein. Bevorzugte Träger sind Kunststofffolien aus PET oder anderen Polyestern.

Die Flexodruckplatte umfasst weiterhin mindestens eine fotopolymerisierbare, reliefbildende Schicht. Die fotopolymerisierbare reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten und/oder elastische Unterschichten.
Zwischen der gegebenenfalls mit einer Haftschicht beschichteten Trägerfolie und der fotopolymerisierbaren, reliefbildenden Schicht kann sich eine elastomere Trägerschicht befinden. Die Trägerschicht kann optional kompressibel oder fotochemisch vernetzbar sein.

Die fotopolymerisierbare reliefbildende Schicht umfasst mindestens ein elastomeres Bindemittel, eine ethylenisch ungesättigte Verbindung, einen Fotoinitiator oder ein Fotoinitiatorsystem sowie optional eine oder mehrere weitere Komponenten, beispielsweise Weichmacher, Verarbeitungshilfsmittel, Farbstoffe und UV-Absorber.

Elastomere Bindemittel zur Herstellung von Flexodruckelementen sind dem Fachmann bekannt. Als Beispiele seien Styrol-Dien-Blockcopolymere, Ethylen-Acrylsäure-Copolymere, Polyethylenoxid-Polyvinylalkohol-Pfropfcopolymere, Naturkautschuk, Polybutadien, Polyisopren, Styrol-Butadien-Kautschuk, Nitril-Butadien-Kautschuk, ButylKautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln löslich oder zumindest quellbar, während sie in Wasser weitgehend unlöslich sind und auch nicht oder zumindest nicht wesentlich in Wasser quellbar sind.

In einer bevorzugten Ausführungsform wird ein Bindemittel vom Styrol-Butadien-Typ eingesetzt. Besonders bevorzugte Bindemittel sind lineare, radiale oder verzweigte Blockcopolymere vom Styrol-Butadien-Typ. Diese Blockcopolymere haben ein mittleres Molekulargewicht M_{w} (Gewichtsmittel) von 80 000 bis 250 000 g/mol, bevorzugt 80 000 bis 150 000 g/mol, und besonders bevorzugt von 90 000 bis 130 000 g/mol und weisen einen Styrolgehalt von 20 bis 40 Gew.-%, bevorzugt 20 bis 35 Gew.-% und besonders bevorzugt von 20 bis 30 Gew.-% auf.

In einer weiteren bevorzugten Ausführungsform handelt es sich um ein Bindemittel vom Styrol-Isopren-Typ. Bevorzugte Bindemittel vom Styrol-Isopren-Typ enthalten in der Regel 13 bis 40 Gew.-%, bevorzugt 13 bis 35 Gew.-% und besonders bevorzugt von 14 bis 30 Gew.-% Styrol.

Die Gesamtmenge an Bindemitteln beträgt im Falle der reliefbildenden Schicht üblicherweise 40 bis 90 Gew.-% bezüglich der Summe aller Bestandteile der reliefbildenden Schicht, bevorzugt 40 bis 80 Gew.-% und besonders bevorzugt 45 bis 75 Gew.-%.
Im Falle einer gegebenenfalls vorhandenen elastomeren Trägerschicht kann die Gesamtmenge an elastomeren Bindemitteln bis zu 100 Gew.-% betragen. Üblicherweise beträgt sie 75 bis 100 Gew.-%, bevorzugt 85 bis 100 Gew.-% und besonders bevorzugt 90 bis 100 Gew.-%.

Die fotopolymerisierbare reliefbildende Schicht umfasst weiterhin in bekannter Art und Weise mindestens eine ethylenisch ungesättigte Verbindung, die mit den Bindemitteln verträglich ist. Geeignete Verbindungen weisen mindestens eine ethylenisch ungesättigte Doppelbindung auf und sind polymerisierbar. Diese werden daher nachfolgend als Monomere bezeichnet. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure, Vinylether, Vinylester oder Allylverbindungen erwiesen. Die Menge an Monomeren beträgt in der fotopolymerisierbaren reliefbildenden Schicht im Regelfalle nicht mehr als 20 Gew.-% bzgl. der Menge aller Bestandteile, im Allgemeinen liegt sie zwischen 3 und 15 Gew.-%.

Die fotopolymerisierbare reliefbildende Schicht umfasst weiterhin in prinzipiell bekannter Art und Weise mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acrylarylphosphinsäureester, α-Hydroxyketone, Mehrkernchinone oder Benzophenone. Die Menge an Fotoinitiator in der reliefbildenden Schicht beträgt in der Regel 0,1 bis 5 Gew.-% bezüglich der Menge aller Bestandteile der reliefbildenden Schicht.

Die elastomere Trägerschicht kann ebenfalls die genannten ethylenisch ungesättigten Verbindungen und die genannten Fotoinitiatoren enthalten, bevorzugt enthält sie diese, ist also wie die reliefbildende Schicht fotopolymerisierbar. Im Allgemeinen beträgt die Menge an ethylenisch ungesättigten Verbindungen in der Trägerschicht 0 bis 15 Gew.-%. Im Allgemeinen beträgt die Menge an Fotoinitiator in der Trägerschicht 0 bis 5 Gew.-%.

Die reliefbildende Schicht und gegebenenfalls die optionale elastomere Trägerschicht können Weichmacher enthalten. Es können auch Gemische verschiedener Weichmacher eingesetzt werden. Bevorzugt sind Polybutadienöle, insbesondere solche mit einem Molekulargewicht zwischen 500 und 5000 g/mol, hochsiedende aliphatische Ester wie insbesondere Alkylmono- und dicarbonsäureester, beispielsweise Stearate oder Adipate, und Mineralöle. Die Menge eines optional vorhandenen Weichmachers wird vom Fachmann je nach den gewünschten Eigenschaften der Schicht bestimmt. Sie wird im Regelfalle 50 Gew.-% der Summe aller Bestandteile der fotopolymerisierbaren reliefbildende Schicht nicht übersteigen, im Allgemeinen beträgt sie 0 bis 50 Gew.-%, bevorzugt 0 bis 40 Gew.-%.

Die Dicke der fotopolymerisierbaren Schicht beträgt im Allgemeinen 0,4 bis 7 mm, bevorzugt 0,5 bis 4 mm und besonders bevorzugt 0,7 bis 2,5 mm.

Die Bebilderung der digital bebilderbaren Schicht wird mittels digitaler Masken vorgenommen. Derartige Masken sind auch als In-situ-Masken bekannt. Hierzu wird zunächst eine digital bebilderbare Schicht auf die fotopolymerisierbare, reliefbildende Schicht aufgebracht. Bevorzugt handelt es sich bei der digital bebilderbaren Schicht um eine IR-ablative Schicht, Ink-Jet-Schicht oder thermografisch beschreibbare Schicht.
Bevorzugt ist die digital bebilderbare Schicht eine mit einem IR-Laser ablatierbare (IR-ablative) Schicht.

IR-ablative Schichten bzw. Masken sind für die Wellenlänge des aktinischen Lichtes opak und umfassen üblicherweise mindestens ein Bindemittel, einen IR-Absorber wie beispielsweise Ruß sowie einen Absorber für UV-Strahlung, wobei die Funktion des IR-Absorbers und UV-Absorbers auch von nur einem Stoff ausgeübt werden kann, was beispielsweise bei der Verwendung von Ruß als IR-Absorber der Fall ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt. werden.

Bei Ink-Jet-Schichten wird eine mit Ink-Jet-Tinten beschreibbare Schicht, beispielsweise eine Gelatine-Schicht aufgetragen. Diese ist mittels Ink-Jet-Druckern bebilderbar.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf oder mittels IR-Lasern bebildert werden.

Optional können sich zwischen der digital bibilderbaren Schicht und der reliefbildenden Schicht noch weitere Funktionsschichten befinden. Beispielsweise können eine dünne, gegen Sauerstoff sperrende Barriereschicht oder eine mit Mattierungsmitteln versehene raue Funktionsschicht, die dem Flexodruckklischee eine definierte Oberflächenrauhigkeit verleiht, vorhanden sein.

Das erfindungsgemäße Verfahren kann durchgeführt werden, indem das Ausgangsmaterial zunächst in eine Aufnahmeeinheit eingelegt wird, beispielsweise durch Auflegen auf ein Förderband oder Bestücken des Magazins. Falls das Ausgangsmaterial eine Schutzfolie aufweist, muss diese für den Fall, dass die Aufnahmeeinheit keine automatische Abzugsvorrichtung aufweist, abgezogen werden.

In dem Verfahrensschritt (a) wird die digital bebilderbare Schicht in einer Bebilderungseinheit mittels der jeweils erforderlichen Technik bebildert. Die Bildinformationen werden direkt einer Steuerungseinheit entnommen.

In dem Verfahrensschritt (b) wird die bebilderte Flexodruckplatte mittels der Belichtungseinheit durch die erzeugte Maske hindurch mittels aktinischem, also chemisch wirksamem Licht bestrahlt.

Bei der Bestrahlung von Flexodruckplatten mittels UV-LED-Leisten in dem genannten Leistungsbereich kann es zu einer lokal, starken Erwärmung der Druckplatte kommen. Insbesondere bei langsamer Fahrweise und hoher Leistung können in der Druckplatte kurzfristig Temperaturen von bis zu 80 °C erreicht werden. Schon um den Temperaturanstieg zu begrenzen, kann es notwendig sein, die gesamte Belichtung in mehrere Teilbelichtungen (Belichtungsschritte) zu unterteilen. Ferner kann es vorteilhaft sein, zwischen LED-Leiste und Druckplattenoberfläche einen Luftrakel zur Kühlung vorzusehen. In einer Ausführungsform der Erfindung wird das Luftrakel mit dem Ein- und Ausschalten der UV-LED-Leiste synchronisiert. Ferner kann die Grundplatte des Belichters mit einer Kühlung versehen werden, um die durch Absorption und chemische Reaktion erzeugte Wärme wieder schnell abführen zu können.

Wird die Druckplatte in mehreren Teilbelichtungen mittels UV-LED belichtet, liegt die pro Belichtungsdurchgang eingetragene Energie zwischen 0,1 und 5 J/cm². Hierbei kann die eingetragene Energie der Teilbelichtungen konstant gehalten werden (konstante Vorschubgeschwindigkeit) oder im Verlaufe der Belichtung gesteigert werden (abnehmende Vorschubgeschwindigkeit). Drucktechnische Untersuchungen zeigen, dass es vorteilhaft sein kann, mehrere Teilbelichtungen mit hoher Vorschubgeschwindigkeit (geringer Energieeintrag) durchzuführen und danach eine oder mehrere Teilbelichtungen mit langsamer Vorschubgeschwindigkeit (hohem Energieeintrag). Beispielsweise werden zuerst 10 bis 40 Belichtungszyklen mit einem Energieeintrag von 0,1 bis 1 J/cm² und anschließend 1 bis 5 Belichtungszyklen mit 2 bis 5 J/cm² durchgeführt.

Die für einen Druckplattentyp und ein Druckplattenformat optimierte Belichtungsart kann nicht unbedingt auf ein anderes Format übertragen werden. Soll ein für ein großes Druckplattenformat optimiertes Belichtungsprogramm mit mehreren Teilbelichtungen auf ein kleineres Format übertragen werden, dann können zwar die optimalen Vorschubgeschwindigkeiten übernommen werden. Um bei der Belichtung des kleineren Formates identische Ergebnisse zu erzielen, müssen dann allerdings zwischen den Teilbelichtungen entsprechende Pausen vorgesehen werden, so dass die Gesamtdauer des Belichtungsvorgangs bei großer und kleiner Flexodruckplatte gleich sind.

Für jeden Flexodruckplattentyp können verschiedene Belichtungsprogramme in der Steuerungseinheit hinterlegt sein. Beispielsweise kann für einen Druckplattentyp ein Programm hinterlegt werden, das im hochqualitativen Rasterdruck auf Folie die besten Resultate liefert (high quality setting). Dieses Belichtungsprogramm kann durch ein zweites Programm ergänzt werden, das eine kurze Gesamtbelichtungsdauer bei guten Druckergebnissen ermöglicht (commercial setting).

Das erfindungsgemäße Belichtungsverfahren gestattet noch weitere Ausführungsformen. Beispielsweise können unterschiedlich dicke Platten parallel belichtet werden. In dieser Ausführungsform wird die Höheneinstellung automatisch korrigiert, sobald die UV-LED-Leiste und der Ultraschallsensor die zweite Flexodruckplatte erreicht hat. Werden mehrere Flexodruckplatten auf dem XY-Tisch in einem Abstand platziert, kann eine "Skip"-Funktion aktiviert werden. Diese ermöglicht es, den Abstand zwischen den Druckplatten mit abgeschalteter UV-LED-Leiste schnell zu überbrücken.

Natürlich ist die erfindungsgemäße UV-LED-Belichtung mit automatischer Dicken- und Formaterfassung nicht auf Ausführungsformen beschränkt, in denen die Druckplatte fest auf dem XY-Tisch verbleibt und sich die UV-LED-Leiste darüber hinweg bewegt.
Insbesondere in einer automatischen Plattenverarbeitungsanlage, in der die Druckplatte mit konstanter Geschwindigkeit transportiert wird und die einzelnen Verarbeitungsschritte durchläuft, wird man die einzelnen Belichtungsschritte mit mehreren fest stehenden UV-LED-Leisten realisieren, unter denen die Platte hindurchläuft. Auch hier können eine oder mehrere UV-LED-Leisten mit Sensoren ausgestattet sein, die den Abstand der Leisten zur Druckplattenoberfläche erfassen und den Belichtungsprozess steuern. Die Erfassung der Dicke der Flexodruckplatten kann auch zur automatischen Einstellung der Auswaschgeschwindigkeit und zur automatischen Höheneinstellung der Waschbürsten in der nachfolgenden Auswascheinheit oder zur Einstellung der Trocknungszeit in dem nachfolgenden Trocknungsschritt herangezogen werden.

In einer weiteren Variante einer automatischen Plattenverarbeitungsanlage wird die Druckplatte mit einer konstanten Geschwindigkeit transportiert, und die mit Sensoren ausgestattete UV-LED-Leiste wird in Transportrichtung mit einer höheren Geschwindigkeit als der Transportgeschwindigkeit hin und her verfahren, um Belichtungszyklen mit geringem Energieeintrag zu realisieren. Anschließend wird die UVA-LED-Leiste in eine stationäre Position am Ende der Belichtungsstrecke verfahren, in der ein Belichtungsschritt mit höherem Energieeintrag realisiert wird. Da eine UV-LED-Leiste in ihrer Leistung nahezu stufenlos regelbar ist, sind hier zahlreiche Varianten möglich.

Alternativ können die Teilbelichtungen mit niedriger Energie auch derart realisiert werden, dass eine UV-LED-Leiste längs zur Bahnrichtung angebracht ist und hin- und her bewegt wird, und am Ende der Belichtungsstrecke dann eine zweite oder dritte UV-LED-Leiste quer zur Transportrichtung durchlaufen wird. Auch in dieser Variante kann die Erkennung der Druckplattendicke und des Druckplattenformats vor der Belichtung erfolgen. Zur Steuerung der UV-LED-Leisten und zum An- und Abschalten der UV-LED-Leisten sind auch in dieser Ausführungsform an den UV-LED-Leisten jeweils eine oder mehrere Ultraschallsensoren angebracht.

Das erfindungsgemäße Belichtungsverfahren ist nicht auf flache Ausführungsformen beschränkt. Die UV-LED-Belichtung kann auch in einer Trommel realisiert werden, auf die die zu belichtende Flexodruckplatte montiert ist. Nach Dicken- und Formaterkennung durch die Ultraschallsensoren wird der Abstand der UV-LED-Leiste zur Druckplattenoberfläche korrigiert und das einprogrammierte Belichtungsverfahren von der Steuerungseinheit gestartet. Verschiedene Energieeinträge und Vorschubgeschwindigkeiten können hier über die Leistungssteuerung der UV-LED-Leiste und über unterschiedliche Umdrehungsgeschwindigkeiten der Trommel realisiert werden. In diesem Verfahren können nicht nur flache Flexodruckplatten sondern auch zylindrische Flexodruckformen verarbeitet werden.

Im Allgemeinen wird vor der UV-LED-Belichtung noch eine Rückseitenvorbelichtung des Flexodruckelements durchgeführt. Dazu wird die Flexodruckplatte von der Rückseite mittels UV-Licht bestrahlt. Die rückseitige UV-Belichtung kann mittels UV-Röhren oder auch mittels UV-LED-Belichtung realisiert werden. Auch dieser Schritt kann in einer UV-LED-Hauptbelichtungseinheit realisiert werden. Hierzu muss die Auflagefläche des UV-LED-Belichters UV-transparent sein, beispielsweise aus Glas bestehen.

In einem Verfahrensschritt (c) wird die bildmäßig bebilderte und belichtete Flexodruckplatte mittels eines geeigneten Lösemittels oder einer Lösemittelkombination entwickelt. Hierbei werden die nicht belichteten, d.h. die von der Maske abgedeckten Bereiche der Reliefschicht entfernt, während die belichteten, d.h. die vernetzten Bereiche erhalten bleiben. Außerdem werden die Reste der digital bebilderbaren Schicht entfernt.

Der Entwicklungsschritt wird üblicherweise bei Temperaturen oberhalb 20°C durchgeführt. Aus Sicherheitsgründen und zur Reduktion des apparativen Aufwands beim Entwicklungsgerät sollte die Temperatur bei der Verwendung organischer Lösemittel 5°C bis 15°C unter dem Flammpunkt des eingesetzten Auswaschmittelgemisches liegen.

Eine Trocknung der Flexodruckplatte kann in einem Verfahrensschritt (d) erfolgen. Weist die Flexodruckplatte einen Träger aus einer PET-Folie auf, erfolgt eine Trocknung vorzugsweise bei einer Temperatur von 40 bis 80°C, besonders bevorzugt bei 50 bis 70°C. Handelt es sich bei dem dimensionsstabilen Träger der Flexodruckplatte um einen Metallträger, kann die Trocknung auch bei höheren Temperaturen bis zu etwa 160°C erfolgen.

Die erhaltenen Flexodruckplatten können in einem Verfahrensschritt (e) bei Bedarf noch einer entklebenden Nachbehandlung durch UVA- und/oder UVC-Licht unterzogen werden. Im Regelfalle ist ein solcher Schritt empfehlenswert. Wenn die Bestrahlung mit Licht unterschiedlicher Wellenlänge vorgesehen ist, kann sie gleichzeitig oder auch nacheinander erfolgen.
Zwischen den einzelnen Verfahrensschritten wird die Flexodruckplatte von einer Einheit zur nächsten weiter transportiert.

Die Entwicklung kann auch thermisch erfolgen. Bei der thermischen Entwicklung wird kein Lösemittel eingesetzt. Stattdessen wird die reliefbildende Schicht nach der bildmäßigen Belichtung mit einem absorbierenden Material in Kontakt gebracht und erwärmt.

## Patentansprüche

1. Verfahren zur Herstellung von Flexodruckformen, bei dem man als Ausgangsmaterial eine fotopolymerisierbare Flexodruckplatte einsetzt, welche übereinander angeordnet mindestens umfasst
• einen dimensionsstabilen Träger,
• mindestens eine fotopolymerisierbare reliefbildende Schicht, mindestens umfassend ein elastomeres Bindemittel, eine ethylenisch ungesättigte Verbindung und einen Fotoinitiator,
• eine digital bebilderbaren Schicht,
umfassend mindestens die folgenden Schritte:
(a) Erzeugung einer Maske durch Bebilderung der digital bebilderbaren Schicht,
(b) Belichtung der Flexodruckplatte durch die Maske hindurch mit aktinischem Licht und Fotopolymerisation der Bildbereiche der Schicht, wobei die Belichtung mit mehreren UV-LEDs erfolgt, die auf mindestens einer relativ zur Oberfläche der Flexoärtrckplatte bewegten UV-LED-Leiste angeordnet sind, und
(c) Entwicklung der fotopolymerisierten Schicht durch Auswaschen und Trocknen oder durch thermische Entwicklung,
**dadurch gekennzeichnet, dass**
- in der UV-LED-Leiste oder in einer separaten Leiste mindestens ein Ultraschallsensor angeordnet ist,
- mit dem mindestens einen Ultraschallsensor mindestens die Dicke der zu belichtenden Flexodruckplatte bestimmt wird,
- die Belichtung der Flexodruckplatte in Abhängigkeit von der gemessenen Dicke der Flexodruckplatte hinsichtlich mindestens eines der Parameter
(i) Zahl der Belichtungsschritte,
(ii) Belichtungsintensität,
(iii) Energieeintrag pro Belichtungsschritt,
(iv) Dauer der einzelnen Belichtungsschritte,
(v) Gesamtdauer der Belichtung
gesteuert wird.

2. Verfahren nach Anspruch 1, **dadurch gekennzeichnet, dass** die Dauer eines einzelnen Belichtungsschrittes und der Energieeintrag pro Belichtungsschritt durch Verfahren der UV-LED-Leiste mit einer Geschwindigkeit im Bereich von 50 mm/min bis 5 000 mm/min relativ zur Oberfläche der Flexodruckplatte eingestellt wird.

3. Verfahren nach Anspruch 1 oder 2, **dadurch gekennzeichnet, dass** mit dem mindestens einen Ultraschallsensor der Abstand der UV-LED-Leiste von der Oberfläche der Flexodruckplatte bestimmt und die UV-LED-Leiste in einem vorbestimmten Abstand positioniert wird.

4. Verfahren nach einem der Ansprüche 1 bis 3, **dadurch gekennzeichnet, dass** in der UV-LED-Leiste oder der separaten Leiste mehrere Ultraschallsensoren angeordnet sind, und zusätzlich die Breite der zu belichtenden Flexodruckplatte bestimmt wird.

5. Verfahren nach einem der Ansprüche 1 bis 3, **dadurch gekennzeichnet, dass** ein Ultraschallsensor beweglich in der UV-LED-Leiste oder der separaten Leiste angeordnet ist, und zusätzlich die Breite der zu belichtenden Flexodruckplatte durch Verfahren der Ultraschallsensoren entlang der Leiste bestimmt wird.

6. Verfahren nach einem der Ansprüche 1 bis 5, **dadurch gekennzeichnet, dass** die Belichtung mehrere Belichtungsschritte umfasst, und die Gesamtdauer der Belichtung durch Pausen zwischen den einzelnen Belichtungsschritten eingestellt wird.

7. Verfahren nach einem der Ansprüche 1 bis 6, **dadurch gekennzeichnet, dass** die Belichtung mehrere Belichtungsschritte umfasst, wobei die UV-LED-Leiste beweglich ist und zwischen einer Ausgangs- und einer Endposition relativ zur Flexodruckplatte hin- und her traversiert.

8. Verfahren nach Anspruch 7, **dadurch gekennzeichnet, dass** die UV-LED-Leiste beim Verfahren von der End- in die Ausgangsposition abgeschaltet wird.

9. Verfahren nach Anspruch 7, **dadurch gekennzeichnet, dass** die UV-LED-Leiste beim Verfahren von der End- in die Ausgangsposition nicht abgeschaltet wird.

10. Verfahren nach Anspruch 7, **dadurch gekennzeichnet, dass** die Belichtung mehrere Belichtungsschritte umfasst, wobei das Verfahren der UV-LED-Leiste mit unterschiedlichen Voxschubgeschwindigkeiten erfolgt.

11. Verfahren nach einem der Ansprüche 1 bis 10, **dadurch gekennzeichnet, dass** die Flexodruckplatte bewegt wird.

12. Verfahren nach Anspruch 11, **dadurch gekennzeichnet, dass** die Belichtung mehrere Belichtungsschritte umfasst, wobei die Flexodruckplatte bewegt wird und eine UV-LED-Leiste beweglich und eine weitere UV-LED-Leiste fest angeordnet ist.

13. Verfahren nach einem der Ansprüche 1 bis 12, **dadurch gekennzeichnet, dass** auf beiden Seiten der UV-LED-Leiste mindestens ein Ultraschallsensor angebracht ist.

14. Verfahren nach einem der Ansprüche 1 bis 13, **dadurch gekennzeichnet, dass** nach Schritt (b) zusätzlich eine Belichtung mit einem UVA-Röhrenbelichter erfolgt.

15. Verfahren nach einem der Ansprüche 1 bis 14, **dadurch gekennzeichnet, dass** vor Schritt (b) zusätzlich eine Rückseitenvorbelichtung der Flexodruclcplatte erfolgt.

16. Vorrichtung zur Belichtung von Flexodruckplatten umfassend einen Auflagetisch zur Aufnahme einer Flexodruckplatte und mindestens einer UV-LED-Leiste, die entlang der Oberfläche des Auflagetischs oder der Oberfläche der Flexodruckplatte beweglich ist, **dadurch gekennzeichnet, dass** mindestens eine UV-LED-Leiste mindestens einen Ultraschallsensor zur Bestimmung der Dicke der Flexodruckplatte und gegebenenfalls der Länge oder der Breite der Flexodruckplatte oder des Abstands der UV-LED-Leiste zu deren Oberfläche aufweist.

17. Vorrichtung nach Anspruch 16, **dadurch gekennzeichnet, dass** die mindestens eine UV-LED-Leiste einen oder mehrere Ultraschallsensoren, die in der Leiste angeordnet sind, oder einen Ultraschallsensor, der längs der Leiste verfahrbar ist, aufweist.

18. Vorrichtung nach Anspruch 17, **dadurch gekennzeichnet, dass** die mindestens eine UV-LED-Leiste mehrere Module aus UV-LED-Arrays aufweist, wobei pro Modul ein Ultraschallsensor längs der Leiste angeordnet ist.

19. Vorrichtung nach einem der Ansprüche 17 oder 18, **dadurch gekennzeichnet, dass** Ultraschallsensoren auf beiden Seiten der mindestens einen Leiste angeordnet sind.

20. Vorrichtung nach Anspruch 16, **dadurch gekennzeichnet, dass** der Ultraschallsensor längs der UV-LED-Leiste beweglich ist.

21. Vorrichtung nach einem der Ansprüche 16 bis 20, **dadurch gekennzeichnet, dass** die mindestens eine UV-LED-Leiste höhenverstellbar ist.

22. Vorrichtung nach einem der Ansprüche 16 bis 21, **dadurch gekennzeichnet, dass** der oder die Ultraschallsensoren mit einer Steuerungseinheit verbunden sind, mit der die Belichtung der Flexodruckplatte hinsichtlich mindestens eines der Parameter
(i) Abstand der LED Leiste von der Oberfläche der Druckplatte
(ii) Zahl der Belichtungsschritte,
(iii) Belichtungsintensität,
(iv) Energieeintrag pro Belichtungsschritt,
(v) Dauer der einzelnen Belichtungsschritte,
(vi) Gesamtdauer der Belichtung,
gesteuert wird.

## Claims

1. Method for producing flexographic printing plates, using as starting material a photopolymerizable flexographic printing plate which at least comprises, arranged one above another,
• a dimensionally stable support,
• at least one photopolymerizable, relief-forming layer, at least comprising an elastomeric binder, an ethylenically unsaturated compound and a photoinitiator,
• a digitally imagable layer,
comprising at least the following steps:
(a) producing a mask by imaging the digitally imagable layer,
(b) exposing the flexographic printing plate through the mask with actinic light, and photopolymerizing the image regions of the layer, the exposing taking place with a plurality of UV-LEDs which are arranged on at least one UV-LED strip which is moved relative to the surface of the flexographic printing plate, and
(c) developing the photopolymerized layer by washing out and drying or by thermal development,
**characterized in that**
- in the UV-LED strip or in a separate strip, at least one ultrasonic sensor is arranged,
- at least the thickness of the flexographic printing plate for exposure is determined with the at least one ultrasonic sensor,
- depending on the measured thickness of the flexographic printing plate, the exposing of the flexographic printing plate is controlled in respect of at least one of the following parameters:
(i) number of exposure steps,
(ii) exposure intensity,
(iii) energy input per exposure step,
(iv) duration of the individual exposure steps,
(v) overall duration of exposure.

2. Method according to Claim 1, **characterized in that** the duration of an individual exposure step and the energy input per exposure step are adjusted by displacing the UV-LED strip at a rate in the range from 50 mm/min to 5000 mm/min relative to the surface of the flexographic printing plate.

3. Method according to Claim 1 or 2, **characterized in that** with the at least one ultrasonic sensor, the distance of the UV-LED strip from the surface of the flexographic printing plate is determined and the UV-LED strip is positioned at a predetermined distance.

4. Method according to any of Claims 1 to 3, **characterized in that** in the UV-LED strip or the separate strip, a plurality of ultrasonic sensors are arranged, and additionally the width of the flexographic printing plate for exposure is determined.

5. Method according to any of Claims 1 to 3, **characterized in that** an ultrasonic sensor is arranged movably in the UV-LED strip or the separate strip, and additionally the width of the flexographic printing plate for exposure is determined by displacement of the ultrasonic sensors along the strip.

6. Method according to any of Claims 1 to 5, **characterized in that** the exposure comprises a plurality of exposure steps, and the overall duration of exposure is adjusted by breaks between the individual exposure steps.

7. Method according to any of Claims 1 to 6, **characterized in that** the exposure comprises a plurality of exposure steps, the UV-LED strip being movable and passing back and forth between a start position and an end position relative to the flexographic printing plate.

8. Method according to Claim 7, **characterized in that** the UV-LED strip is switched off when being displaced from the end position into the start position.

9. Method according to Claim 7, **characterized in that** the UV-LED strip is not switched off when being displaced from the end position into the start position.

10. Method according to Claim 7, **characterized in that** the exposure comprises a plurality of exposure steps, the displacing of the UV-LED strip taking place at different advancement rates.

11. Method according to any of Claims 1 to 10, **characterized in that** the flexographic printing plate is moved.

12. Method according to Claim 11, **characterized in that** the exposure comprises a plurality of exposure steps, the flexographic printing plate being moved and one UV-LED strip being movably arranged and another UV-LED strip being fixedly arranged.

13. Method according to any of Claims 1 to 12, **characterized in that** on both sides of the UV-LED strip at least one ultrasonic sensor is mounted.

14. Method according to any of Claims 1 to 13, **characterized in that** after step (b), additionally, exposure takes place with a UVA tube exposure unit.

15. Method according to any of Claims 1 to 14, **characterized in that** before step (b), additionally, preliminary reverse exposure of the flexographic printing plate takes place.

16. Apparatus for the exposure of flexographic printing plates, comprising a placement stage for accommodating a flexographic printing plate and at least one UV-LED strip, which is movable along the surface of the placement stage or the surface of the flexographic printing plate, **characterized in that** at least one UV-LED strip has at least one ultrasonic sensor for determining the thickness of the flexographic printing plate and optionally the length or the width of the flexographic printing plate or the distance of the UV-LED strip from the plate surface.

17. Apparatus according to Claim 16, **characterized in that** the at least one UV-LED strip has one or more ultrasonic sensors which are arranged in the strip, or one ultrasonic sensor which is displaceable along the strip.

18. Apparatus according to Claim 17, **characterized in that** the at least one UV-LED strip has a plurality of modules composed of UV-LED arrays, there being one ultrasonic sensor per module arranged along the strip.

19. Apparatus according to either of Claims 17 and 18, **characterized in that** ultrasonic sensors are arranged on both sides of the at least one strip.

20. Apparatus according to Claim 16, **characterized in that** the ultrasonic sensor is movable along the UV-LED strip.

21. Apparatus according to any of Claims 16 to 20, **characterized in that** the at least one UV-LED strip is height-adjustable.

22. Apparatus according to any of Claims 16 to 21, **characterized in that** the ultrasonic sensor or sensors are connected to a control unit with which the exposing of the flexographic printing plate is controlled in respect of at least one of the following parameters:
(i) distance of the LED strip from the surface of the printing plate,
(ii) number of exposure steps,
(iii) exposure intensity,
(iv) energy input per exposure step,
(v) duration of the individual exposure steps,
(vi) overall duration of exposure.

## Revendications

1. Procédé de fabrication de moules de flexographie, selon lequel une plaque de flexographie photopolymérisable est utilisée en tant que matériau de départ, qui comprend au moins, agencés les uns sur les autres :
- un support de dimensions stables,
- au moins une couche photopolymérisable formant un relief, comprenant au moins un liant élastomère, un composé éthyléniquement insaturé et un photoinitiateur,
- une couche apte à former numériquement une image,
comprenant au moins les étapes suivantes :
(a) la formation d'un masque par formation d'une image sur la couche apte à former numériquement une image,
(b) l'éclairage de la plaque de flexographie au travers du masque avec une lumière actinique et la photopolymérisation des zones d'image de la couche, l'éclairage ayant lieu avec plusieurs DEL UV, qui sont agencées sur au moins une barre de DEL UV déplacée par rapport à la surface de la plaque de flexographie, et
(c) le développement de la couche photopolymérisée par lavage et séchage ou par développement thermique,
**caractérisé en ce que**
- au moins un capteur d'ultrasons est agencé dans la barre de DEL UV ou dans une barre séparée,
- au moins l'épaisseur de la plaque de flexographie à éclairer est déterminée avec ledit au moins un capteur d'ultrasons,
- l'éclairage de la plaque de flexographie est réglé en fonction de l'épaisseur mesurée de la plaque de flexographie au regard d'au moins un des paramètres suivants :
(i) le nombre d'étapes d'éclairage,
(ii) l'intensité d'éclairage,
(iii) l'apport d'énergie par étape d'éclairage,
(iv) la durée des étapes d'éclairage individuelles,
(v) la durée totale de l'éclairage.

2. Procédé selon la revendication 1, **caractérisé en ce que** la durée des étapes d'éclairage individuelles et l'apport d'énergie par étape d'éclairage sont ajustées par un déplacement de la barre de DEL UV avec une vitesse dans la plage allant de 50 mm/min à 5 000 mm/min par rapport à la surface de la plaque de flexographie.

3. Procédé selon la revendication 1 ou 2, **caractérisé en ce que** la distance entre la barre de DEL UV et la surface de la plaque de flexographie est déterminée avec ledit au moins un capteur d'ultrasons et la barre de DEL UV est positionnée à une distance prédéterminée.

4. Procédé selon l'une quelconque des revendications 1 à 3, **caractérisé en ce que** plusieurs capteurs d'ultrasons sont agencés dans la barre de DEL UV ou la barre séparée, et la largeur de la plaque de flexographie à éclairer est en outre déterminée.

5. Procédé selon l'une quelconque des revendications 1 à 3, **caractérisé en ce qu'**un capteur d'ultrasons est agencé mobile dans la barre de DEL UV ou la barre séparée, et la largeur de la plaque de flexographie à éclairer est en outre déterminée par déplacement des capteurs d'ultrasons le long de la barre.

6. Procédé selon l'une quelconque des revendications 1 à 5, **caractérisé en ce que** l'éclairage comprend plusieurs étapes d'éclairage, et la durée totale de l'éclairage est ajustée par des pauses entre les étapes d'éclairage individuelles.

7. Procédé selon l'une quelconque des revendications 1 à 6, **caractérisé en ce que** l'éclairage comprend plusieurs étapes d'éclairage, la barre de DEL UV étant mobile et ayant un mouvement de va-et-vient entre une position initiale et une position finale par rapport à la plaque de flexographie.

8. Procédé selon la revendication 7, **caractérisé en ce que** la barre de DEL UV est éteinte pendant le déplacement de la position finale à la position initiale.

9. Procédé selon la revendication 7, **caractérisé en ce que** la barre de DEL UV n'est pas éteinte pendant le déplacement de la position finale à la position initiale.

10. Procédé selon la revendication 7, **caractérisé en ce que** l'éclairage comprend plusieurs étapes d'éclairage, le déplacement de la barre de DEL UV ayant lieu avec différentes vitesses d'avancement.

11. Procédé selon l'une quelconque des revendications 1 à 10, **caractérisé en ce que** la plaque de flexographie est déplacée.

12. Procédé selon la revendication 11, **caractérisé en ce que** l'éclairage comprend plusieurs étapes d'éclairage, la plaque de flexographie étant déplacée et une barre de DEL-UV étant agencée mobile et une autre barre de DEL UV étant agencée fixe.

13. Procédé selon l'une quelconque des revendications 1 à 12, **caractérisé en ce qu'**au moins un capteur d'ultrasons est disposé sur les deux côtés de la barre de DEL UV.

14. Procédé selon l'une quelconque des revendications 1 à 13, **caractérisé en ce qu'**un éclairage avec un dispositif d'éclairage à tubes UVA a en outre lieu après l'étape (b).

15. Procédé selon l'une quelconque des revendications 1 à 14, **caractérisé en ce qu'**un pré-éclairage du côté arrière de la plaque de flexographie a en outre lieu avant l'étape (b).

16. Dispositif pour l'éclairage de plaques de flexographie, comprenant une table de travail destinée à recevoir une plaque de flexographie et au moins une barre de DEL UV, qui est mobile le long de la surface de la table de travail ou de la surface de la plaque de flexographie, **caractérisé en ce qu'**au moins une barre de DEL UV comprend au moins un capteur d'ultrasons pour la détermination de l'épaisseur de la plaque de flexographie et éventuellement de la longueur ou de la largeur de la plaque de flexographie ou de la distance entre la barre de DEL UV et sa surface.

17. Dispositif selon la revendication 16, **caractérisé en ce que** ladite au moins une barre de DEL UV comprend un ou plusieurs capteurs d'ultrasons qui sont agencés dans la barre ou un capteur d'ultrason qui est déplaçable le long de la barre.

18. Dispositif selon la revendication 17, **caractérisé en ce que** ladite au moins une barre de DEL UV comprend plusieurs modules de réseaux de DEL UV, un capteur d'ultrasons par module étant agencé le long de la barre.

19. Dispositif selon l'une quelconque des revendications 17 ou 18, **caractérisé en ce que** des capteurs d'ultrasons sont agencés sur les deux côtés de ladite au moins une barre.

20. Dispositif selon la revendication 16, **caractérisé en ce que** le capteur d'ultrasons est mobile le long de la barre DEL UV.

21. Dispositif selon l'une quelconque des revendications 16 à 20, **caractérisé en ce que** ladite au moins une barre DEL UV est ajustable en hauteur.

22. Dispositif selon l'une quelconque des revendications 16 à 21, **caractérisé en ce que** le ou les capteurs d'ultrasons sont raccordés avec une unité de réglage, avec laquelle l'éclairage de la plaque de flexographie est réglé au regard d'au moins un des paramètres suivants :
(i) la distance entre la barre de DEL et la surface de la plaque de flexographie,
(ii) le nombre d'étapes d'éclairage,
(iii) l'intensité d'éclairage,
(iv) l'apport d'énergie par étape d'éclairage,
(v) la durée des étapes d'éclairage individuelles,
(vi) la durée totale de l'éclairage.
